# EUROPÄISCHE PATENTSCHRIFT

(11) **EP 0 909 464 B1**
(45) Veröffentlichungstag und Bekanntmachung des Hinweises auf die Patenterteilung: **26.01.2005**
(21) Anmeldenummer: 97931736.9
(22) Anmeldetag: 01.07.1997
(51) Int. Cl.: H01L 51/20, H01L 51/30

(54) **ELEKTROLUMINESZIERENDE ANORDNUNGEN**
ELECTROLUMINESCENT ARRANGEMENTS
SYSTEMES ELECTROLUMINESCENTS

(30) Priorität: 05.07.1996 DE 19627071
(43) Veröffentlichungstag der Anmeldung: 21.04.1999
(73) Patentinhaber: BAYER AG, 51368 Leverkusen (DE)
(72) Erfinder: JONAS, Friedrich, D-52066 Aachen (DE); ELSCHNER, Andreas, D-45479 Mülheim (DE); WEHRMANN, Rolf, D-47800 Krefeld (DE); QUINTENS, Dirk, B-2500 Lier (BE)
(86) Internationale Anmeldenummer: PCT/EP1997/003437
(87) Internationale Veröffentlichungsnummer: WO 1998/001909

(56) Entgegenhaltungen:
- EP-A- 0 440 957
- EP-A- 0 443 861
- EP-A- 0 643 118
- EP-A- 0 686 662
- WO-A-90/13148
- WO-A-95/24056

## Beschreibung

Die Erfindung betrifft elektrolumineszierende Anordnungen, die bestimmte leitfähige 3,4 Polythiophene als loch- und/oder elektroneninjizierende Schicht enthalten.

Eine Elektrolumineszierende (EL) Anordnung ist dadurch charakterisiert, daß sie unter Anlegung einer elektrischen Spannung unter Stromfluß Licht aussendet. Derartige Anordnungen sind unter der Bezeichnung "Leuchtdioden" (LEDs = light emitting diodes) seit langem in der Technik bekannt. Die Emission von Licht kommt dadurch zustande, daß positive Ladungen ("Löcher", holes) und negative Ladungen ("Elektronen", electrons) unter Aussendung von Licht kombinieren.

Die in der Technik gebräuchlichen LEDs bestehen alle zum überwiegenden Teil aus anorganischen Halbleitermaterialien. Seit einigen Jahren sind jedoch EL-Anordnungen bekannt, deren wesentliche Bestandteile organische Materialien sind.

Diese organischen EL-Anordnungen enthalten in der Regel eine oder mehrere Schichten aus organischen Ladungstransportverbindungen.

Der prinzipielle Schichtaufbau ist wie folgt. Die Zahlen 1 bis 10 bedeuten dabei:
1 Träger, Substrat
2 Basiselektrode
3 Löcher-injizierende Schicht
4 Löcher-transportierende Schicht
5 Emitter-Schicht
6 Elektronen-transportierende Schicht
7 Elektronen-injizierende Schicht
8 Topelektrode
9 Kontakte
10 Umhüllung, Verkapselung

Dieser Aufbau stellt den allgemeinsten Fall dar und kann vereinfacht werden, indem einzelne Schichten weggelassen werden, so daß eine Schicht mehrere Aufgaben übernimmt. Im einfachsten Fall besteht eine EL-Anordnung aus zwei Elektroden, zwischen denen sich eine organische Schicht befindet, die alle Funktionen - inklusive der der Emission von Licht - erfüllt. Derartige Systeme sind z.B. in der Anmeldung WO 9013148 auf der Basis von Poly-[p-phenylenvinylen] beschrieben.

Bei der Herstellung von großflächigen, elektrolumineszierenden Anzeigeelementen muß mindestens eine der stromzuführenden Elektroden 2 oder 8 aus einem transparenten und leitfähigen Material bestehen.

Als Substrat 1 sind transparente Träger wie Glas oder Kunststoff-Folien (z.B. Polyester, wie Polyethylenterephthalat oder Polyethylennaphthalat, Polycarbonat, Polyacrylat, Polysulfon, Poly-imid-Folie) geeignet.

Als transparente und leitfähige Materialien sind geeignet:
a) Metalloxide, z.B. Indium-Zinn-Oxid (ITO), Zinnoxid (NESA), etc.,
b) semi-transparente Metallfilme, z.B. Au, Pt, Ag, Cu, etc..

Als Emitterschicht 5 können in den erfindungsgemäßen Anwendungen sowohl niedermolekulare oder oligomere als auch polymere Materialien eingesetzt werden. Die Substanzen zeichnen sich dadurch aus, daß sie photolumineszierend sind. Das heißt, es sind Fluoreszenzfarbstoffe bzw. fluoreszierende Moleküle und deren Umsetzungsprodukte zu Oligomeren oder deren Einbau in Polymere geeignet.

Beispiele für derartige Materialien sind Cumarine, Perylene, Anthracene, Phenanthrene, Stilbene, Distyryle, Methine oder Metallkomplexe wie Alq₃ usw.. Als Polymere sind gegebenenfalls substituierte Phenylene, Phenylenvinylene oder Polymere mit fluoreszierenden Segmenten in der Polymerseitenkette oder im Polymerrückgrat geeignet. Eine umfassende Zusammenstellung ist in EP-A 532 798 wiedergegeben.

Es hat sich aber in der Praxis gezeigt, daß zur Erhöhung der Leuchtdichte elektronen- bzw. lochinjizierende Schichten (3,4 und/oder 6,7) in die elektrolumineszierenden Aufbauten eingebaut werden müssen.

In der Literatur wird eine Vielzahl von organischen Verbindungen beschrieben, die Ladungen (Löcher und/oder Elektronen) transportieren. Verwendet werden überwiegend niedermolekulare Substanzen, die z.B. im Hochvakuum aufgedampft werden. Einen guten Überblick über die Substanzklassen und ihre Verwendung geben z.B. die Veröffentlichungen EP-A 387 715, US-A 4 539 507, 4 720 432 und 4 769 292.

Nachteilig ist hierbei das Aufbringen durch Aufdampfen im Hochvakuum. Zur Vereinfachung des Herstellungsverfahrens von ELP Anzeigen würde es von Vorteil sein, wenn die Schichten 3,4 und 6,7 z.B. durch Aufbringen aus Lösung hergestellt werden können.

Aus der EP-A 686 662 ist bekannt, spezielle Mischungen aus leitfähigen organischen polymeren Leitern wie 3,4-Polyethylendioxythiophen und Polyhydroxyverbindungen oder Lactamen als Elektrode 1 in ELP-Aufbauten einzusetzen.

In Synthetic Metals 76 (1996) 141-143 wird Poly-(3,4-ethylendioxythiophen) ebenfalls als Elektrode in LED's beschrieben, wobei darauf hingewiesen wird, daß das Poly-(3,4-ethylendioxythiophen) gegenüber Indiumzinnoxid (ITO) Elektroden nur zu niedrigeren Leuchtdichten führt.

Überraschenderweise wurde jetzt gefunden, daß bestimmte 3,4-Polyethylendioxythiophere als ladungsinjizierende Zwischenschicht auf transparenten Elektroden wie ITO zu Leuchtdichten in LED's führt, die den LED's mit reinem Metallelektroden bzw. reinen leitfähigen Polymerelektroden deutlich überlegen sind. Diese Schichten können aus Lösung oder durch direkte Polymerisation der den polymeren organischen Leitern entsprechenden Monomeren hergestellt werden.

Die geeigneten 3,4 Polythiophene sind neutrale oder kationische Thiophene der Formel (I) 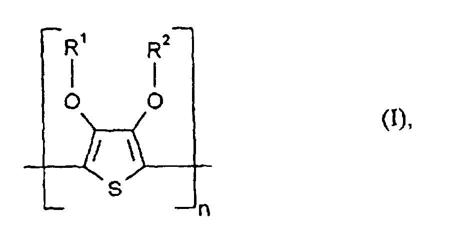 wobei
- R¹ und R²: unabhängig voneinander für Wasserstoff, gegebenenfalls substituiertes C₁-C₂₀-Alkyl, CH₂OH oder C₆-C₁₄-Aryl stehen oder
- R¹ und R²: zusammen -(CH₂)ₘ-CH₂- mit m = 0 bis 12, vorzugsweise 1 bis 5, C₆-C₁₄-Arylen bedeuten, und
- n: für eine ganze Zahl von 5 bis 100 steht.

Vorzugsweise stehen R¹ und R² für -(CH₂)ₗ-CH₂- mit 1 = 1 bis 4.

Die Polythiophene der wiederkehrenden Struktureinheit der Formel (I) sind bekannt (vgl. EP-A 440 957 und 339 340). Die Herstellung der erfindungsgemäßen Dispersionen bzw. Lösungen ist in EP-A 440 957 und DE-OS 4 211 459 beschrieben.

Die Polythiophene werden in der Dispersion bzw. Lösung bevorzugt in kationischer Form, wie sie z.B. durch Behandlung der neutralen Thiophene mit Oxidationsmitteln erhalten werden, eingesetzt. Übliche Oxidationsmittel wie Kaliumperoxodisulfat werden für die Oxidation verwendet. Durch die Oxidation erhalten die Polythiophene positive Ladungen, die in den Formeln nicht dargestellt sind, da ihre Zahl und ihre Position nicht einwandfrei feststellbar sind. Gemäß den Angaben in EP-A 339 340 können sie direkt auf Trägern hergestellt werden.

Als Polyanionen dienen die Anionen von polymeren Carbonsäuren, wie Polyacrylsäuren, Polymethacrylsäuren, oder Polymaleinsäuren und polymeren Sulfonsäuren, wie Polystyrolsulfonsäuren und Polyvinylsulfonsäuren. Diese Polycarbon- und -sulfonsäuren können auch Copolymere von Vinylcarbon- und Vinylsulfonsäuren mit anderen polymerisierbaren Monomeren, wie Acrylsäureestern und Styrol, sein.

Das Molekulargewicht der die Polyanionen liefernden Polysäuren beträgt vorzugsweise 1 000 bis 2 000 000, besonders bevorzugt 2 000 bis 500 000. Die Polysäuren oder ihre Alkalisalze sind im Handel erhältlich, z.B. Polystyrolsulfonsäuren und Polyacrylsäuren, oder aber nach bekannten Verfahren herstellbar (siehe z.B. Houben-Weyl, Methoden der organischen Chemie, Bd. E 20 Makromolekulare Stoffe, Teil 2 (1987), S. 1141 u.f.).

Anstelle der für die Bildung der erfindungsgemäßen Dispersionen aus Polythiophenen und Polyanionen erforderlichen freien Polysäuren, kann man auch Gemische aus Alkalisalzen der Polysäuren und entsprechenden Mengen an Monosäuren einsetzen.

Die Polythiophen-Dispersionen in Gegenwart von Polyanionen werden durch oxidative Polymerisation von 3,4-Dialkoxy-thiophenen der Formel 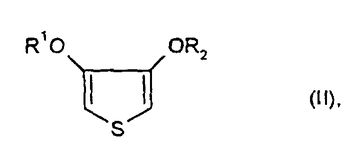 in der
- R₁ und R₂: die unter Formel (I) angegebene Bedeutung haben,
mit für die oxidative Polymerisation von Pyrrol üblichen Oxidationsmitteln und/oder Sauerstoff oder Luft in Gegenwart der Polysäuren, bevorzugt in wäßrigem Medium, bei Temperaturen von 0 bis 100°C erhalten. Durch die oxidative Polymerisation erhalten die Polythiophene positive Ladungen, die in den Formeln nicht dargestellt sind, da ihre Zahl und ihre Position nicht einwandfrei feststellbar sind.

Zur Polymerisation werden die Thiophene der Formel (II), Polysäure und Oxidationsmittel in einem organischen Lösungsmittel oder - vorzugsweise - in Wasser gelöst und die Lösung solange bei der vorgesehenen Polymerisationstemperatur gerührt, bis die Polymerisation abgeschlossen ist.

Bei Verwendung von Luft oder Sauerstoff als Oxidationsmittel wird in die Thiophen, Polysäure und gegebenenfalls katalytische Menge an Metallsalzen enthaltende Lösung solange Luft oder Sauerstoff eingeleitet bis die Polymerisation abgeschlossen ist.

In Abhängigkeitg von Ansatzgröße, Polymerisationstemperatur und Oxidationsmittel kann die Polymerisationszeit zwischen wenigen Minuten und bis zu 30 Stunden betragen. Im allgemeinen liegt die Zeit zwischen 30 Minuten und 10 Stunden. Die Stabilität der Dispersionen läßt sich durch während oder nach der Polymerisation zugefügte Dispergatoren wie Dodecylsulfonat verbessern.

Als Oxidationsmittel können die für die oxidative Polymerisation von Pyrrol geeigneten Oxidationsmittel verwendet werden; diese sind beispielsweise in J. Am. Chem. Soc. 85, 454 (1963) beschrieben. Bevorzugt sind aus praktischen Gründen preiswerte und leicht handhabbare Oxidationsmittel, z.B. Eisen-III-Salze wie FeCl₃, Fe(ClO₄)₃ und die Eisen-III-Salze organischer Säuren und organische Reste aufweisender anorganischer Säuren, ferner H₂O₂, K₂Cr₂O₇, Alkali- und Ammoniumpersulfate, Alkaliperborate, Kaliumpermanganat und Kupfersalze, wie Kupfertetrafluoroborat. Außerdem wurde gefunden, daß sich Luft und Sauerstoff, gegebenenfalls in Gegenwart katalytischer Mengen Metallionen, wie Eisen-, Cobalt-, Nickel-, Molybdän- und Vanadiumionen, mit Vorteil aus Oxidationsmittel verwenden lassen.

Bei der oxidativen Polymerisation werden die Polysäuren in einer solchen Menge eingesetzt, daß auf 1 mol Thiophen der Formel (II) 0,25 bis 10, vorzugsweise 0,8 bis 8, insbesondere 1,9 bis 8 Säuregruppen der Polysäure entfallen.

Das Verfahren ist in EP-A 440 957 beschrieben. Bevorzugt werden entsalzte Lösungen nach DE-OS 4 211 459 hergestellt.

Die Polythiophen-Dispersion bzw. Lösung kann zusätzlich filtriert werden. Bevorzugt werden filtrierte Dispersionen bzw. Lösungen eingesetzt. Die Porengröße der verwendeten Filter liegt vorzugsweise unter 0,5 µm.

Gegenstand der Erfindung sind daher elektrolumineszierende Anordnungen nach Anspruch 1, die wenigstens eine loch- und/oder elektroneninjizierende Schicht aus den oben genannten 3,4 Polythiophenen gemäß Formel I enthalten.

Die Zwischenschichten können aus Lösung auf die Basiselektrode 2 und/oder die Emitterschicht 5 aufgebracht werden.

Dazu wird bei den erfindungsgemäßen Systemen z.B. eine Lösung des 3,4-Polyethylendioxythiophens auf der Basiselektrode als Film verteilt. Als Lösungsmittel werden bevorzugt Wasser bzw. Wasser Alkoholgemische verwendet. Geeignete Alkohole sind z.B. Methanol, Ethanol, Propanol, Isopropanol.

Die Verwendung dieser Lösungsmittel hat den Vorteil, daß dann weitere Schichten aus organischen Lösungsmitteln, wie aromatischen oder aliphatischen Kohlenwasserstoffgemischen aufgebracht werden können, ohne daß die Schicht 3,4 angegriffen wird. Gleiches gilt für das Aufbringen der Schicht 6,7 auf die Emitterschicht 5.

Die Lösung des polymeren organischen Leiters wird durch Techniken wie Spincoaten, Casting, Rakeln, Drucken, Vorhanggießen etc. auf dem Substrat gleichmäßig verteilt. Anschließend werden die Schichten bei Raumtemperatur oder Temperaturen bis 300°C, bevorzugt 200°C getrocknet.

Die Lösung des organischen Leiters kann auch strukturiert auf die gegebenenfalls strukturierte Basiselektrode aufgebracht werden. Geeignete Verfahren zur Herstellung der strukturierten loch- und/oder elektroneninjizierenden Schichten sind z.B. Siebdruck, Tiefdruck, Aufsprühen durch strukturierte Schablonen, Gravuroffsetdruck, Tampondruck, Aufstempeln mit strukturierten Stempeln.

Die Dicke der Zwischenschicht beträgt etwa 3 bis 100 nm, vorzugsweise 10 nm bis 50 nm.

Den Lösungen der 3,4 Polythiophene können außerdem organische, polymere Bindemittel und/oder organische, niedermolekulare Vernetzungsmittel zugesetzt werden. Entsprechende Bindemittel sind z.B. in der EP 564 911 beschrieben.

Auf der Basiselektrode können die erfindungsgemäßen Zwischenschichten 3,4 auch durch elektrochemische Polymerisation der den 3,4 Polythiophene entsprechenden Monomere erzeugt werden. Diese Verfahren sind bekannt und z.B. in EP 339 340 beschrieben.

### Beispiele

### Herstellung der 3,4-Polyethylendioxythiophenlösung (PEDT/PSS Stammlösung)

20 g freie Polystyrolsulfonsäure (Mn ca. 40.000), 21,4 g Kaliumperoxodisulfat und 50 mg Eisen(III)-sulfat werden unter Rühren in 2.000 ml Wasser vorgelegt. Unter Rühren werden 8,0 g 3,4-Ethylendioxythiophen zugegeben. Die Lösung wird 24 h bei Raumtemperatur gerührt. Anschließend werden 100 g Anionenaustauscher (Handelsprodukt Bayer AG Lewatit MP 62) und 100 g Kationenaustauscher (Handelsprodukt Bayer AG Lewatit S 100), beide wasserfeucht, zugegeben und 8 Stunden gerührt.

Die Ionenaustauscher werden durch Filtration entfernt. Es wird eine Lösung mit einem Feststoffgehalt von ca. 1,2 Gew.-% erhalten, die gebrauchsfertig ist.

### Beispiel 1

Bei der Herstellung einer elektrolumineszierenden Anordnung mit erfindungsgemäßer PEDT/PSS-Zwischenschicht wurde folgendermaßen vorgegangen.

### a) Reinigung des ITO

ITO beschichtetes Glas (hergestellt von der Firma Balzers) wird in 20 x 30 mm große Stücke geschnitten und in folgenden Schritte gereinigt:
1. 15 min in destilliertem Wasser/Falterol-Spülmittel (basisch) im Ultraschallbad,
2. 2 x 15 min in jeweils frischem destilliertem Wasser im Ultraschallbad spülen,
3. 15 min in Ethanol im Ultraschallbad,
4. 2 x 15 min in jeweils frischem Aceton im Ultraschallbad,
5. Trocknen auf fusselfreien Linsentüchern.

### b) Aufbringen der PEDT/PSS-Schicht auf das ITO

2 Vol.-Teile der gefilterten PEDT/PSS-Stammlösung werden mit 1 Vol.-Teil Methanol gemischt. Etwa 1 ml dieser Lösung wird auf dem gereinigten ITO-Substrat verteilt. Die überstehende Lösung wird mit einem Spin-coater 30 sec lang bei 1.500 U/min abgeschleudert. Der Film wird anschließend 20 min lang bei 70°C im Trockenschrank getrocknet. Die Schichtdicke wird mit einem Stylusprofilometer (Tencor 200) bestimmt und beträgt 50 nm.

### c) Aufbringen der elektrolumineszierenden Schicht

Auf die getrocknete PEDT/PSS-Schicht wird eine zweite Schicht, die elektrolumineszierende Schicht, aufgebracht. Dazu wird eine 1 %ige-Lösung aus 7 Gew.-Teilen Poly(vinylcarbazol) (PVK) (Aldrich) und 3 Gew.-Teilen Methinfarbstoff (EP-A 699 730) hergestellt. Die Lösung wird gefiltert und 1 ml der Lösung wird auf dem PEDT/PSS verteilt. Die überstehende Lösung wird mit einem Spin-coater 30 sec lang bei 1.000 U/min abgeschleudert. Anschließend wird die Probe 20 min lang bei 50°C im Vakuumtrockenschrank getrocknet. Die Gesamtschichtdicke der Probe beträgt danach 150 nm.

### d) Aufdampfen der Metall-Elektroden und elektrische Kontaktierung

Die Probe wird in eine Aufdampfapparatur (Leybold 600) eingebaut. Eine Lochmaske mit einem Lochdurchmesser von 3 mm wird auf die polymere Schicht gelegt. Bei einem Druck von 10⁻⁵ mbar wird Al von einem Target mittels einer Elektronenstrahlkanone gegen die polymere Schicht gedampft. Die Al-Schichtdicke beträgt 500 nm. Die beiden Elektroden der organischen LED werden über elektrische Zuführungen mit einer Spannungsquelle verbunden. Der positive Pol ist mit dem ITO-Elektrode, der negative Pol ist mit der Al-Elektrode verbunden.

### e) Bestimmung der Elektrolumineszenz

Bereits bei kleinen Spannungen (U = 5 Volt) fließt ein Strom von 1 mA/cm² durch die Anordnung. Bei 8 Volt läßt sich mit einer Photodiode Elektrolumineszenz nachweisen. Bei 20 Volt beträgt die Elektrolumineszenzintensität 50 cd/m² (Minolta, LS 100).

Das Kontrollexperiment ohne die erfindungsgemäße PEDT/PSS-Zwischenschicht führt zu niedrigeren EL-Intensitäten und zu einer höheren Einsatzspannung.

### Beispiel 2

Bei der Herstellung einer elektrolumineszierenden Anordnung mit erfindungsgemäßer PEDT/PSS-Zwischenschicht wurde folgendermaßen vorgegangen.

### a) Reinigung des ITO

ITO beschichtetes Glas (hergestellt von der Firma Balzers) wird in 20 x 30 mm große Stücke geschnitten und in folgenden Schritte gereinigt:
1. 15 min in destilliertem Wasser/Falterol-Spülmittel (basisch) im Ultraschallbad,
2. 2 x 15 min in jeweils frischem destilliertem Wasser im Ultraschallbad spülen,
3. 15 min in Ethanol im Ultraschallbad,
4. 2 x 15 min in jeweils frischem Aceton im Ultraschallbad,
5. Trocknen auf fusselfreien Linsentüchern.

### b) Aufbringen der PEDT/PSS-Schicht auf das ITO

2 Vol.-Teile der gefilterten PEDT/PSS-Stammlösung werden mit 1 Vol.-Teil Methanol gemischt. Etwa 1 ml dieser Lösung wird auf dem gereinigten ITO-Substrat verteilt. Die überstehende Lösung wird mit einem Spin-coater 30 sec lang bei 1.500 U/min abgeschleudert. Der Film wird anschließend 20 min lang bei 70°C im Trockenschrank getrocknet. Die Schichtdicke wird mit einem Stylusprofilometer (Tencor 200) bestimmt und beträgt 50 nm.

### c) Aufbringen der elektrolumineszierenden Schicht

Auf die getrocknete PEDT/PSS-Schicht wird eine zweite Schicht, die elektrolumineszierende Schicht, aufgebracht. Dazu wird eine 1,5 %ige-Lösung aus 7 Gew.-Teilen Poly(vinylcarbazol) (PVK) (Aldrich) und 3 Gew.-Teilen Cumarin 6 (Lambda Physics) hergestellt. Die Lösung wird gefiltert und 1 ml der Lösung wird auf dem PEDT/PSS verteilt. Die überstehende Lösung wird mit einem Spin-coater 10 sec lang bei 1.800 U/min abgeschleudert.

### d) Aufdampfen der Metall-Elektroden und elektrische Kontaktierung

Die Probe wird in eine Aufdampfapparatur (Leybold 600) eingebaut. Eine Lochmaske mit einem Lochdurchmesser von 3 mm wird auf die polymere Schicht gelegt. Bei einem Druck von 10⁻⁵ mbar wird Al von einem Target mittels einer Elektronenstrahlkanone gegen die polymere Schicht gedampft. Die Al-Schichtdicke beträgt 500 nm. Die beiden Elektroden der organischen LED werden über elektrische Zuführungen mit einer Spannungsquelle verbunden. Der positive Pol ist mit dem ITO-Elektrode, der negative Pol ist mit der Al-Elektrode verbunden.

### e) Bestimmung der Elektrolumineszenz

Bereits bei kleinen Spannungen (U = 10 Volt) fließt ein Strom von 0, 1 mA/cm² durch die Anordnung. Bei 8 Volt läßt sich mit einer Photodiode Elektrolumineszenz nachweisen. Bei 20 Volt beträgt die Elektrolumineszenzintensität 10 cd/m² (Minolta, LS 100).

### Beispiel 3

Bei der Herstellung einer elektrolumineszierenden Anordnung mit erfindungsgemäßer PEDT/PSS-Zwischenschicht wurde folgendermaßen vorgegangen.

### a) Reinigung des ITO

ITO beschichtetes Glas (hergestellt von der Firma Balzers) wird in 20 x 30 mm große Stücke geschnitten und in folgenden Schritte gereinigt:
1. 15 min in destilliertem Wasser/Falterol-Spülmittel (basisch) im Ultraschallbad,
2. 2 x 15 min in jeweils frischem destilliertem Wasser im Ultraschallbad spülen,
3. 15 min in Ethanol im Ultraschallbad,
4. 2 x 15 min in jeweils frischem Aceton im Ultraschallbad,
5. Trocknen auf fusselfreien Linsentüchem.

### b) Aufbringen der PEDT/PSS-Schicht auf das ITO

2 Vol.-Teile der gefilterten PEDT/PSS-Stammlösung werden mit 1 Vol.-Teil Methanol gemischt. Etwa 1 ml dieser Lösung wird auf dem gereinigten ITO-Substrat verteilt. Die überstehende Lösung wird mit einem Spin-coater 30 sec lang bei 1.500 U/min abgeschleudert. Der Film wird anschließend 20 min lang bei 70°C im Trockenschrank getrocknet. Die Schichtdicke wird mit einem Stylusprofilometer (Tencor 200) bestimmt und beträgt 50 nm.

### c) Aufbringen der elektrolumineszierenden Schicht

Auf die getrocknete PEDT/PSS-Schicht wird eine zweite Schicht, die elektrolumineszierende Schicht, aufgebracht. Dazu wird eine 1,5 %ige-Lösung aus 7 Gew.-Teilen Poly(vinylcarbazol) (PVK) (Aldrich) und 3 Gew.-Teilen Perylenfarbstoff KF 856 (Handelsprodukt der BASF) hergestellt. Die Lösung wird gefiltert und 1 ml der Lösung wird auf dem PEDT/PSS verteilt. Die überstehende Lösung wird mit einem Spin-coater 10 sec lang bei 1.800 U/min abgeschleudert. Die Gesamtschichtdicke der Probe beträgt danach 140 nm.

### d) Aufdampfen der Metall-Elektroden und elektrische Kontaktierung

Die Probe wird in eine Aufdampfapparatur (Leybold 600) eingebaut. Eine Lochmaske mit einem Lochdurchmesser von 3 mm wird auf die polymere Schicht gelegt. Bei einem Druck von 10⁻⁵ mbar wird Al von einem Target mittels einer Elektronenstrahlkanone gegen die polymere Schicht gedampft. Die Al-Schichtdicke beträgt 500 nm. Die beiden Elektroden der organischen LED werden über elektrische Zuführungen mit einer Spannungsquelle verbunden. Der positive Pol ist mit dem ITO-Elektrode, der negative Pol ist mit der Al-Elektrode verbunden.

### e) Bestimmung der Elektrolumineszenz

Bereits bei kleinen Spannungen (U = 5 Volt) fließt ein Strom von 1 mA/cm² durch die Anordnung. Bei 4 Volt läßt sich mit einer Photodiode Elektrolumineszenz nachweisen. Bei 15 Volt beträgt die Elektrolumineszenzintensität 30 cd/m² (Minolta, LS 100).

Das Kontrollexperiment ohne die erfindungsgemäße PEDT/PSS-Zwischenschicht führt zu niedrigeren EL-Intensitäten und zu einer höheren Einsatzspannung.

### Beispiel 4

a) In eine Lösung aus 0,8 g Tetramethylammoniumtetrafluoroborat und 0,28 g 3,4-Ethylendioxythiophen in 100 ml Acetonitril wird ein nach Beispiel la gereinigtes ITO-Substrat und ein 1 x 2 cm² großes Platinblech gehängt. Die Glasplatte wird als Anode geschaltet. In 20 Sekunden wird bei einer Spannung von 2 V und einem Strom von 1,5 mA eine dünne 3,4-Polyethylendioxythiophenschicht als lochinjizierende Zwischenschicht abgeschieden.
b) Auf die getrocknete PEDT-Schicht wird eine zweite Schicht, die elektrolumineszierende Schicht, aufgebracht. Dazu wird eine 1 %ige-Lösung aus 7 Gew.-Teilen Poly(vinylcarbazol) (PVK) (Aldrich) und 3 Gew.-Teilen Methinfarbstoff (EP-A 699 730) hergestellt. Die Lösung wird gefiltert und 1 ml der Lösung wird auf dem PEDT verteilt. Die überstehende Lösung wird mit einem Spin-coater 30 sec lang bei 1.000 U/min abgeschleudert.
   Anschließend wird die Probe 20 min lang bei 50°C im Vakuumtrockenschrank getrocknet. Die Gesamtschichtdicke der Probe beträgt danach 150 nm.

### c) Aufdampfen der Metall-Elektroden und elektrische Kontaktierung

Die Probe wird in eine Aufdampfapparatur (Leybold 600) eingebaut. Eine Lochmaske mit einem Lochdurchmesser von 3 mm wird auf die polymere Schicht gelegt. Bei einem Druck von 10⁻⁵ mbar wird Al von einem Target mittels einer Elektronenstrahlkanone gegen die polymere Schicht bedampft. Die Al-Schichtdicke beträgt 500 nm. Die beiden Elektroden der organischen LED werden über elektrische Zuführungen mit einer Spannungsquelle verbunden. Der positive Pol ist mit dem ITO-Elektrode, der negative Pol ist mit der Al-Elektrode verbunden.

### d) Bestimmung der Elektrolumineszenz

Bereits bei kleinen Spannungen (U = 5 Volt) fließt ein Strom von 1 mA/cm² durch die Anordnung. Bei 4 Volt läßt sich mit einer Photodiode Elektrolumineszenz nachweisen. Bei 20 Volt beträgt die Elektrolumineszenzintensität 10 cd/m² (Minolta, LS 100).

Das Kontrollexperiment ohne die erfindungsgemäße PEDT-Zwischenschicht führt zu niedrigeren EL-Intensitaten und zu einer höheren Einsatzspannung.

## Patentansprüche

1. Elektrolumineszierende Anordnung, die wenigstens eine ladungsinjizierende Zwischenschicht aus neutralen oder kationischen Polythiophenen der Formel (I) enthält, 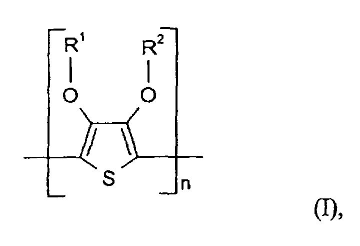 wobei
R¹ und R² unabhängig voneinander für Wasserstoff, gegebenenfalls substituiertes C₁-C₂₀-Alkyl, CH₂OH oder C₆-C₁₄-Aryl stehen oder
R¹ und R² zusammen -(CH₂)ₘ-CH₂- mit m = 0 bis 12, vorzugsweise 1 bis 5, C₆-C₁₄-Arylen bedeuten, und
n für eine ganze Zahl von 5 bis 100 steht,
wenigstens eine transparente und leitfätige Elektrode enthält und
die ladungsinjiziernde Zwischenschicht auf die transparente Elektrode aufgebracht ist.

2. Elektrolumineszierende Anordnung gemäß Anspruch 1, **dadurch gekennzeichnet, dass** die Verbindungen der Formel (I) in kationischer Form in Gegenwart von Polyanionen von polymeren Carbonsäuren vorliegen.

3. Elektrolumineszierende Anordnung gemäß Anspruch 1, **dadurch gekennzeichnet, dass** die Polyanionen ausgewählt sind aus der Gruppe der Polyacrylsäuren, Polymethacrylsäuren, Polymaleinsäuren, Polystyrolsulfonsäuren und Polyvinylsulfonsäuren oder deren Salze, wobei die Polycarbon- und sulfonsäuren auch Copolymere von Vinylcarbon- und Vinylsulfonsäuren mit anderen polymerisierbaren Monomeren sein können.

4. Elektrolumineszierende Anordnung gemäß Anspruch 3, **dadurch gekennzeichnet, dass** Polystyrolsulfonsäure oder das entsprechende Alkalisalz das Polyanion ist.

5. Elektrolumineszierende Anordnung gemäß wenigstens einem der Ansprüche 1 bis 4, **dadurch gekennzeichnet, dass** die transparente Elektrode ein Metalloxid oder ein semitransparenter Metallfilm ist.

6. Elektrolumineszierende Anordnung gemäß Anspruch 5, **dadurch gekennzeichnet, dass** das Metalloxid ausgewählt ist aus der Gruppe Indium-Zinn-Oxid (ITO) oder Zinnoxid (NESA) oder der semitransparente Metallfilm ausgewählt aus der Gruppe Au, Pt, Ag oder Cu ist.

7. Elektrolumineszierende Anordnung gemäß wenigstens einem der Ansprüche 1 bis 6, **dadurch gekennzeichnet, dass** die transparente Metallelektrode eine Indium-Zinn-Oxid (ITO)-Elektrode ist.

## Claims

1. Electroluminescent arrangement which comprises at least one charge-injecting intermediate layer of uncharged or cationic polythiophenes of the formula (I), 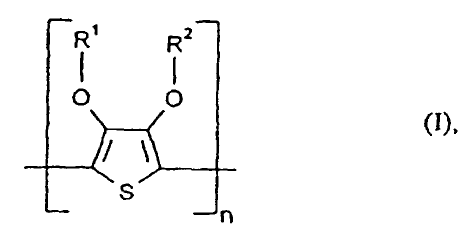 where
R¹ and R² are each, independently of one another, hydrogen, optionally substituted C₁-C₂₀-alkyl, CH₂OH or C₆-C₁₄-aryl or
R¹ and R² together form -(CH₂)ₘ-CH₂-, where m = 0 to 12, preferably from 1 to 5, C₆-C₁₄-arylene, and
n is an integer from 5 to 100,
and at least one transparent and conductive electrode,
with the charge-injecting intermediate layer having been applied to the transparent electrode.

2. Electroluminescent arrangement according to Claim 1, **characterized in that** the compounds of the formula (I) are present in cationic form in the presence of polyanions of polymeric carboxylic acids.

3. Electroluminescent arrangement according to Claim 1, **characterized in that** the polyanions are selected from the group consisting of polyacrylic acids, polymethacrylic acids, polymaleic acids, polystyrenesulphonic acids and polyvinylsulphonic acids and salts thereof, with the polycarboxylic and polysulphonic acids also being able to be copolymers of vinylcarboxylic and vinylsulphonic acids with other polymerizable monomers.

4. Electroluminescent arrangement according to Claim 3, **characterized in that** polystyrenesulphonic acid or the corresponding alkali metal salt is the polyanion.

5. Electroluminescent arrangement according to at least one of Claims 1 to 4, **characterized in that** the transparent electrode is a metal oxide or a semitransparent metal film.

6. Electroluminescent arrangement according to Claim 5, **characterized in that** the metal oxide is selected from the group consisting of indium-tin oxide (ITO) and tin oxide (NESA) or the semitransparent metal film is selected from the group consisting of Au, Pt, Ag and Cu.

7. Electroluminescent arrangement according to at least one of Claims 1 to 6, **characterized in that** the transparent metal electrode is an indium-tin oxide (ITO) electrode.

## Revendications

1. Système électroluminescent qui contient au moins une couche intermédiaire injectant des charges à partir de polythiophènes neutres ou cationiques de formule (I) 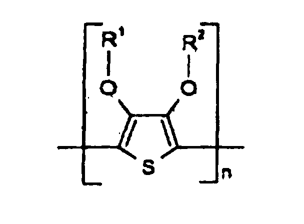 dans laquelle
R¹ et R² désignent , indépendamment l'un de l'autre, l'hydrogène, un radical C₁-C₂₀-alkyle éventuellement substitué, CH₂OH ou C₆-C₁₄-aryle ou
R¹ et R² désignent ensemble -(CH₂)ₘ-CH₂- avec m = 0 à 12, de préférence 1 à 5, ou C₆-C₁₄-arylène et
n désigne un nombre entier de 5 à 100,
qui contient au moins une électrode transparente et conductrice et
la couche intermédiaire d'injection de charge est appliquée sur l'électrode transparente.

2. Système électroluminescent selon la revendication 1, **caractérisé en ce que** les composés de formule (I) sont présents sous forme cationique en présence de polyanions d'acides carboxyliques polymères.

3. Système électroluminescent selon la revendication 1, **caractérisé en ce que** les polyanions sont sélectionnés dans le groupe des acides polyacryliques, de acides polyméthacryliques, des acides polymaléiques, des acides polystyrènesulfoniques et des acides polyvinylsulfoniques ou leurs sels, les acides polycarboxyliques et sulfoniques pouvant aussi être des copolymères d'acides vinylcarboxyliques ou vinylsulfoniques avec d'autres monomères polymérisables.

4. Système électroluminescent selon la revendication 3, **caractérisé en ce que** l'acide polystyrènesulfonique ou le sel alcalin correspondant est le polyanion.

5. Système électroluminescent selon au moins l'une des revendications 1 à 4, **caractérisé en ce que** l'électrode transparente est un oxyde métallique ou un film métallique semi-transparent.

6. Système électroluminescent selon la revendication 5, **caractérisé en ce que** l'oxyde métallique est sélectionné dans le groupe de oxyde d'indium-étain (ITO) ou l'oxyde d'étain (NESA) ou le film métallique semi-transparent est sélectionné dans le groupe Au, Pt, Ag ou Cu.

7. Système électroluminescent selon au moins l'une des revendications 1 à 6, **caractérisé en ce que** l'électrode métallique transparente est une électrode d'oxyde d'indium-étain (ITO).
